Europäisches Patentamt

European Patent Office

Office européen des brevets

(11) Publication number: **0 522 182 A1**

## EUROPEAN PATENT APPLICATION
### published in accordance with Art. 158(3) EPC

(21) Application number: 92904244.8

(22) Date of filing: **30.01.92**

(86) International application number:
**PCT/JP92/00089**

(87) International publication number:
**WO 92/13811 (20.08.92 92/22)**

(51) Int. Cl.⁵: **C04B 35/58**, H01L 35/34

(30) Priority: **30.01.91 JP 9770/91**
     **15.04.91 JP 80350/91**
     **29.05.91 JP 126138/91**

(43) Date of publication of application:
     **13.01.93 Bulletin 93/02**

(84) Designated Contracting States:
     **BE DE FR GB IT NL**

(71) Applicant: **IDEMITSU PETROCHEMICAL CO. LTD.**
     **1-1, Marunouchi 3-chome Chiyoda-ku Tokyo 100(JP)**

(72) Inventor: **TOKIAI, Takeo, Idemitsu Petrochemical Company Ldt.**
     **1660, Kamiizumi**
     **Sodegaura-shi, Chiba-ken 299-02(JP)**
     Inventor: **UESUGI, Takashi, Idemitsu Petrochemical Co., Ltd.**
     **1-1, Marunouchi 3-chome Chiyoda-ku, Tokyo 100(JP)**

(74) Representative: **Hartmann, Günter, Dr. Dipl.-Chem.**
     **Pienzenauerstrasse 2**
     **W-8000 München 80(DE)**

(54) **METHOD FOR MANUFACTURING THERMOELECTRIC ELEMENT.**

(57) A method of manufacturing thermoelectric elements having a high excellent electric performance index and a high thermoelectric conversion efficiency at a cost and at a high efficiency. A solution including a dopant metal (e.g., an aqueous solution of manganese nitrate) is mixed with a material powder for a thermoelectric conversion (e.g., $Fe_{0.92}Mn_{0.08}Si_{2.05}$, $Fe_{0.99}Cr_{0.01}Si_{2.00}$, $Fe_{0.85}Ru_{0.10}Co_{0.05}Si_{2.00}$ and $Fe_{0.85}Ru_{0.10}Cr_{0.04}Si_{2.00}$). The pH of the aqueous solution of the mixture thus obtained is adjusted to produce the precipitate. The separated precipitate is cleaned and dried. The obtained powder is calcined and shaped by pressing. Then, by performing a sintering and heat treatment, the thermoelectric conversion element is manufactured.

EP 0 522 182 A1

F I G . 1

EXAMPLE 4

COM.EXAMPLE 1

ELECTRICAL PERFORMANCE INDEX $\alpha^2 \cdot \sigma / (10^{-4} Wm^{-1} K^{-2})$

TEMPERATURE (℃)

TECHNICAL FILED

The present invention relates to a process for preparing a thermo-element, and more particularly, to an efficient and economical process for preparing a thermo-element capable of transforming thermal energy into electricity with a high efficiency and for example, suitable for an electric generator.

BACKGROUND ART

A thermo-element which directly transforms thermal energy into electric energy has physical properties of a large thermoelectric power (Seebeck coefficient), a small specific resistance and a small thermal conductivity.

Heretofore, thermo-elements are widely used for thermo-sensors and power sources for hot current blowers.

Recently, $FeSi_2$, $CrSi_2$, SiGe(GaP), PbTe, SiC, etc. have been expected to be suitably used for thermo-electric power generators for high temperatures because of their excellent heat resisting properties, as is known. Therefore, a thermo-element with a high performance index and with a high transforming efficiency is desired.

Heretofore, many processes are proposed as methods for producing a thermo-element, e.g. (1) a crystalline ingot method which consists of mixing, melting and molding materials into ingots to be sliced, (2) a powdered metal technique, a method of preparing a thermo-element from iron silicide through a melting process, a grinding process, a pulverizing process by a ball mill, a cold pressing process, a sintering process and a heat-treating process (see, for example, Japanese Patent Publication No. 47,677/1977, Japanese Patent Kokai (laid-open) Nos. 63,870/1982, 43,882/1985 and 140,062/1988) and (3) a plasma method, a method of preparing a thermo-element by super-pulverizing, molding, sintering and heat-treating many kinds of raw materials of the thermo-element (see, for example, Japanese Patent Kokai (laid-open) No. 248,678/1989).

The crystalline ingot method, however, generally has defects, is incapable of obtaining a desired shape and has low yields caused by a loss from slicing. The powdered metal technique has only given thermo-elements having a low transformation efficiency. The plasma method produces super-pulverized powder as a raw material with low efficiency and the obtained thermo-element shows limited performance and stablity.

A process for producing a thermo-element in which part of the Fe in $FeSi_2$ is replaced by Ru and doping metals has been reported (see "A Technique of Transforming Energy", a report of the 1990 study by Masahiko Shimada, belonging to the engineering department of Tohoku University). The reported process is as follows: Powdery Fe, powdery Ru and powdery Si were mixed at a predetermined rate. The mixture was packed in a quartz tube under a vacuum and calcined at 1100°C for 48 hours. The calcined mixture was annealed at 900 °C to 1050 °C for seven days. Crystalline phases of the obtained powder were identified by X-ray powder diffraction analysis. A sample having only the $\beta$ -phase was sintered. The specific resistance and the thermoelectric power of the sintered body were measured at a temperature of 300K-1000K. The methods of preparing the sintered body were the vacuum encapsulation method and ultra-high pressure sintering method. The latter was conducted using a high pressure belt apparatus under the pressure of 3 GPa, at the temperature of 800°C and for 1 hour (disclosed in page 1, "2. Method of Experiment", lines 1-12 of the report). As mentioned above, the process described in the report is to produce a thermo-element by mixing the powder, calcining and sintering the mixed powder.

However, the thermo-element produced by this method has still insufficient thermoelectric power although it shows rather high performance at a high temperature.

DISCLOSURE OF INVENTION

Therefore, an object of the present invention is to provide an efficient and economical process for preparing a thermo-element with a high performance index and capable of transforming thermal energy into electricity with a high efficiency.

The another object of this invention is to provide a process for preparing a thermo-electric element having an advantageous high efficiency at a high temperature.

In order to achieve the objects, the present invention uses a process for preparing a thermo-electric element characterized by mixing a powdery thermo-electric transformation raw material and a solution containing a doping metal to obtain a powder, molding the powder to obtain an article and sintering the molded article into a certain shape.

Particulary, a thermo-electric element with a high electrical performance index at a high temperature of 500°C to 700 °C can be obtained, when the powdery thermo-electric transformation raw material is an alloy represented by the following formula:

$$Fe_{1-z}M^1_zSi_2$$

wherein z is 0 to 0.2, $M^1$ is at least one metal selected from the group consisting of Mn, Cr, Co, Ni and Al, or another alloy represented by the following formula:

$$Fe_{1-(x+y)}M^3_xM^2_ySi_2$$

wherein $M^2$ is at least one metal selected from the group consisting of Mn, Cr, Co, Ni and Al, $M^3$ is Ru or Os and (x + y) is 0.1 to 0.3; and the doping metal is at least one metal selected from the group consisting of Mn, Cr, Co, Ni and Al.

BRIEF DESCRIPTION OF DRAWING

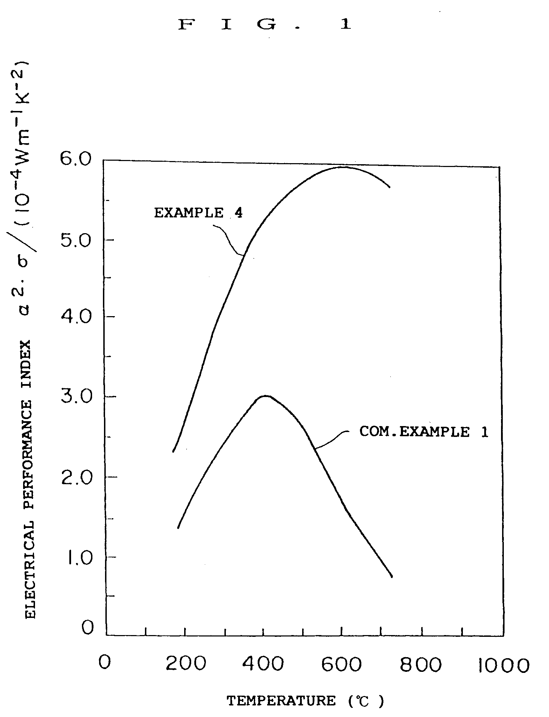

Figures 1 to 7 show the relation between the electrical performance index of the thermo-electric element and the temperature, respectively.

BEST MODE FOR CARRYING OUT THE INVENTION

The process of the present invention will be described in detail in order of the preparation steps.

(1) Step of obtaining a powder to be molded

In the present invention, a powder to be shaped was prepared by mixing a powdery thermo-electric transformation raw material and a solution containing a doping metal.

- Powdery Thermo-electric Transformation Raw Material -

The powdery thermo-electric transformation raw material according to the present invention is not restricted to a particular one. Examples are $FeSi_2$, $CoSi_2$, $SiGe(GaP)$, $CrSi_2$, $MnSi_2$, $PbTe$, $GeTe$, $AgSbTe_2$, $B_4C$, $SiC$, $Mg_2Si$, $RuSi_2$ and $ReSi_2$. $FeSi_2$ is particularly preferred which is an excellent powdery thermo-electric transformation raw material because it can be converted into a thermo-electric element with very great thermoelectromotive force. The above-mentioned raw materials can be used alone or in combination with each other.

A more preferred powdery thermo-electric transformation raw material except for the above-mentioned is a powdery alloy containing a doping metal represented by the following formula (1):

$$Fe_{1-z}M^1_zSi_2$$

wherein z is 0 to 0.2, $M^1$ is at least one metal selected from the group consisting of Mn, Cr, Co, Ni and Al. Examples of the alloy powder are $Fe_{0.92}Mn_{0.08}Si_{2.05}$ obtained by substituting a doping metal Mn for Fe in $FeSi_2$ or a part of $FeSi_2$; $Fe_{0.95}Co_{0.05}Si_{2.05}$, $Fe_{0.995}Cr_{0.005}Si_{2.05}$ and $FeAl_{0.10}Si_{1.90}$ obtained by substituting doping metals Co, Cr and Al, respectively, for part of the $FeSi_2$.

The powdery thermo-electric transformation raw material may have a metallic phase, semiconductive phase or the mixture of both. The powdery thermo-electric transformation raw material having the semiconductive phase can be obtained, when it is one belonging to the $FeSi_2$ system, by heating it having the metallic phase at 700 to 900°C for 10 to 250 hours.

The average particle size of the powdery thermo-electric transformation raw material, especially that of the alloy powder represented by the formula (1) according to the present invention, is about 0.1 to 100 $\mu$ m and preferably 1 to 20$\mu$ m.

Another preferred powdery thermo-electric transformation raw material is another powdery alloy represented by the following formula (2):

$$Fe_{1-(x+y)}M^3_xM^2_ySi_2$$

wherein $M^2$ is at least one metal selected from the group consisting of Mn, Cr, Co, Ni and Al, $M^3$ is Ru or

4

Os and (x + y) is 0.1 to 0.3. The amount of the composition allows $Si_{2.00\pm0.1}$, more preferably $Si_{2.00\pm0.05}$, so long as the powdery alloy is capable of thermo-electric transformation.

The powdery thermoelectric transformation raw material according to the present invention is preferably a molten alloy consisting of Fe and Si with the doping metal, and Ru or Os substituting for part of Fe in $FeSi_2$. The amount of the composition of the molten alloy is shown in the above formula (2). The sum of x and y is 0.1 to 0.3, and x may be 0.

The powdery thermoelectric transformation raw material having the composition represented by the formula (2) can be produced as an alloy by melting Fe, Ru or Os, the doping metal, and Si in inert atmosphere.

The average particle size of the thermoelectric transformation raw material powder according to the present invention, especially that of the alloy powder represented by the formula (2) is usually 1 to 50 $\mu$ m and preferably 1 to 20$\mu$ m. The raw material powder represented by this particular composition formula and having the average particle size can be obtained by pulverizing a ground raw material with a planetary ball mill at 800 r.p.m. for 1 to 72 hours.

- Solution Containing a Doping Metal -

Preferred examples of the doping metal is Mn, Cr, Co, Ni and Al. As a solution containing the above-mentioned doping metal, an aqueous solution containing a salt of the doping metal or a solution of an organometallic compound containing the doping metal may be used.

As the salt of the doping metal, nitrates, chlorides, sulfates, carbonates, oxalates, etc. can be used. Detailed examples are $Mn(NO_3)_2 \cdot 6H_2O$, $Cr(NO_3)_2 \cdot 9H_2O$, $Cr(NO_3)_2 \cdot 6H_2O$, $Co(NO_3)_2 \cdot 6H_2O$, $Ni(NO_3)_2 \cdot 6H_2O$, $Al(NO_3)_3 \cdot 9H_2O$, $Mn(CO_3)_2 \cdot 6H_2O$, $Cr_2(CO_3)_3 \cdot 9H_2O$, $Co_2(CO_3)_3 \cdot 6H_2O$, $Ni_2(CO_3)_2 \cdot 6H_2O$, $Al_2(CO_3)_3 \cdot 9H_2O$, $Mn_2(C_2O_4)_2 \cdot 6H_2O$, $Cr_2(C_2O_4)_3 \cdot 9H_2O$, $Co_2(C_2O_4)_3 \cdot 6H_2O$, $Ni_2(C_2O_4)_3 \cdot 6H_2O$ and $Al_2(C_2O_4)_3 \cdot 9H_2O$.

As the organometallic compound containing the doping metal, alkoxides, carboxylates, etc. of metals may be used. A preferred form is soluble in a solvent, such as water or alcohol which is easy to precipitate in the form of minute particles in the thermoelectric transformation raw material powder.

As the solvent dissolving the organometallic compound, water, alcohol, glycol, etc. can be used.

The kind of the powdery raw material and the amount of the doping metal contained therein determine the amount of the solution containing the doping metal, the concentration of doping metal salt in the aqueous solution, the concentration of the organometallic compound contaianing the doping metal in the solution. For example, when the doping metal is in the form of nitrate, it may be in the range from 0.2 part to 30 parts by weight, preferably from 0.5 part to 20 parts by weight, based on 100 parts by weight of the powdery thermoelectric transformation raw material. Other parameters are readily determinable following the general process provided herein.

In this step, the powdery thermoelectric transformation raw material is mixed with the solution containing the doping metal, preferably the mixture obtained is agitated to control precipitation, and thus the precipitates are obtained.

Procedures for adjusting pH of the mixture and certain pH values are not restricted. An example is to add a necessary amount of pH adjusting agent such as aqueous ammonia, sodium hydroxide, ammonium hydroxide, hydrochloric acid and nitric acid.

The period of time required for the agitation is usually from 0.01 to 70 hours.

The precipitates are separated from the solvent by known methods such as filtration and centrifugal separation. The separated precipitates are washed by ordinary methods and then dried or presintered. The resulting powder has thermoelectric transforming performance.

(2) Step of preparing a Thermo-element from the Powder

A thermo-element is prepared from the powder with thermoelectric transforming performance by known methods. For example, pressing the powder, preferably after a pre-sintering, and a shaped article obtained by the press is sintered and in some cases a sintered article is further heated, to result in the thermo-element.

The pre-sintering may be carried out in an inert atmosphere, e.g. in argon gas atmosphere, or under vacuum, at a temperature of usually from 300 to 1,200 °C, preferably from 350 to 800 °C.

The press may be performed by known methods under the known conditions which are often adopted in producing thermo-elements. That is, the powder with thermoelectric transforming performance is pressed with a cold isostatic press, a hot isostatic press, a hot press, a dry press and the like at a room temperature or an increased temperature.

The sintering may be performed under the known conditions which are often adopted in producing thermo-elements by known methods such as hot isostatic pressing treatment (HIP treatment), pressure sintering and vacuum sintering. For example, the sintering is performed under a decreased pressure of $10^{-1}$- $10^{-6}$ torr at a temperature of 1,000-1,200°C for 1-50 hours.

The heating performed after the sintering, if needed, is usually carried out at a temperature of 700 to 1,000°C under a decreased pressure of $10^{-1}$ to $10^{-6}$ torr for 1 to 200 hours.

The thermo-element obtained has a high performance index and is capable of transforming thermal energy into electricity with a high efficiency.

(Examples 1-4)

A certain amount of aqueous solution of 0.1M manganese nitrate was added to a thermo-electric transformation raw material powder [$Fe_{0.92}Mn_{0.08}Si_{2.05}$; metallic phase] as shown in Table 1 with the amount of manganese nitrate being 5.3 parts by weight based on 100 parts by weight of the thermoelectric transformation raw material powder. The mixture was agitated at a room temperature. 25% aqueous ammonia was added to the mixture with the mixture being agitated for 0.2 hour to adjust its pH to 9.0 or more. Precipitates were obtained.

The precipitates were filtered with a cylindrical paper filter, washed with ion-exchanged water and dried at 90 °C for 5 hours. Then, in order to remove nitric acid, the dried precipitates were pre-sintered in the flow of argon gas at a temperature of 400 to 500°C for 5 hours to obtain a powder.

The powder was pressed with a cool isostatic press at a pressure of 4.0 ton/cm$^2$ for 3 minutes to obtain a shaped article of 2mm × 5mm × 30mm. This shaped article was sintered at 1,150 °C for 24 hours under $10^{-5}$ torr and further heated at 800°C for 144 hours under $10^{-5}$ torr to obtain a desired thermo-element.

The thermoelectric character of the obtained thermo-element at 600 °C measured is shown in Table 1. The relation between the electrical performance index of the thermo-element obtained in Example 4 and the temperature is shown in Figure 1.

(Comparative Example 1)

The thermo-element was prepared in substantially the same manner as in Examples 1-4, except for using the thermoelectric transformation raw material powder without the treatment with manganese nitrate. The thermoelectric character of the obtained thermo-element at 600 °C measured is shown in Table 1. The relationship between the electrical performance index of the obtained thermo-element and the temperature is shown in Figure 1.

(Example 5)

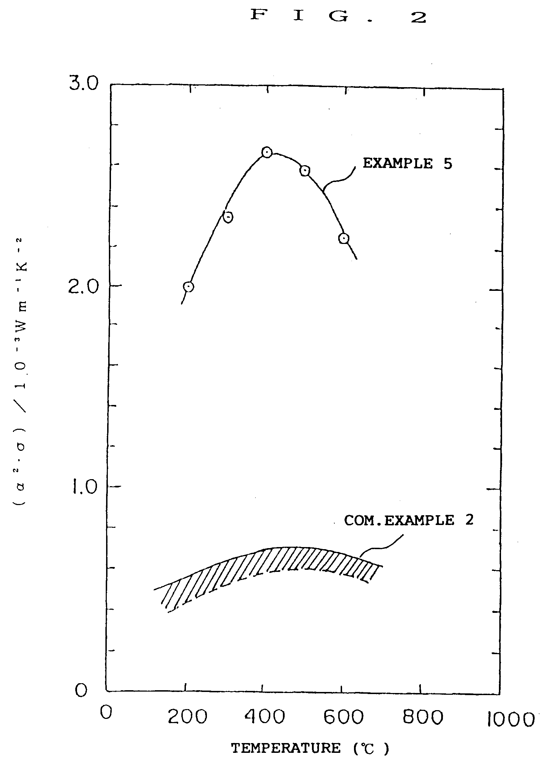

The thermo-element was prepared in substantially the same manner as in Examples 1-4, except for using [$Fe_{0.95}Co_{0.05}Si_{2.00}$: metallic phase] as the thermoelectric transformtion raw material powder and 0.1M cobalt nitrate as the aqueous solution containing the salt of the doping metal. The thermoelectric character of the obtained thermo-element at 600 °C measured is shown in Table 1. The relationship between the electrical performance index of the obtained thermo-element and the temperature is shown in Figure 2.

(Comparative Example 2)

The thermo-element was prepared in substantially the same manner as in Example 5, except for using the thermoelectric transformation raw material powder without the treatment with cobalt nitrate. The thermoelectric character of the obtained thermo-element at 600°C measured is shown in Table 1. The relationship between the electrical performance index of the obtained thermo-element and the temperature is shown in Figure 2.

(Example 6)

An aqueous solution of 0.1M chromium nitrate [$Cr(NO_3)_2$] was added to a thermo-electric transformation raw material powder [particle size: 5-6 $\mu$ m, $Fe_{0.99}Cr_{0.01}Si_{2.00}$; metallic phase] with the rate of chromium nitrate being 5.3 parts by weight based on 100 parts by weight of the powdery thermoelectric transformation raw material. The mixture was agitated at a room temperature. 25% aqueous ammonia was added to the mixture with the mixture being agitated for 0.2 hour to adjust its pH to 10. Precipitates were obtained.

The precipitates were filtered with a cylindrical paper filter, washed with ion-exchanged water and dried at 90 °C for 5 hours. Then, the dried precipitates were pre-sintered under a flow of argon gas at a temperature of 400 to 500°C for 5 hours to obtain a powder.

The powder was pressed with a cool isostactic press at a pressure of 4.0 ton/cm$^2$ for 3 minutes to obtain a shaped article of 2mm × 5mm × 30mm. This shaped article was sintered at 1,150 °C for 24 hours under 10$^{-5}$ torr and further heated at 800°C for 144 hours under 10$^{-5}$ torr to obtain a desired thermo-element.

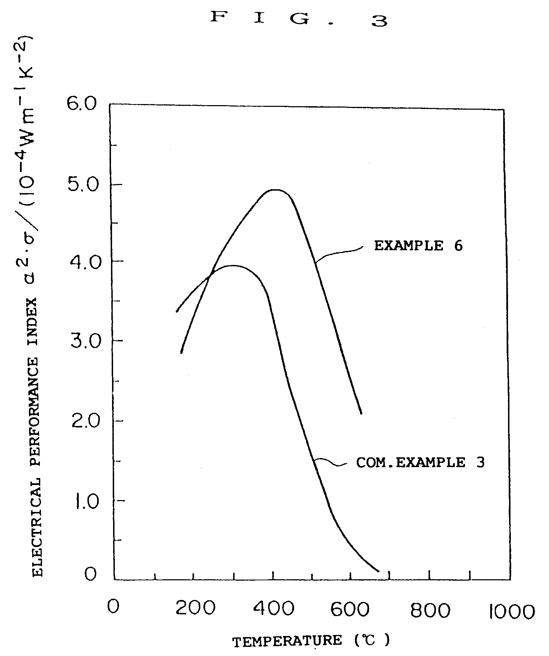

The relationship between the electrical performance index of the thermo-element obtained in Example 4 and the temperature is shown in Figure 3.

(Comparative Example 3)

The thermo-element was prepared in substantially the same manner as in Example 6, except for using the thermoelectric transformation raw material powder without the treatment with chromium nitrate. The relationship between the electrical performance index of the obtained thermo-element and the temperature is shown in Figure 3 for the purpose of comparison with Example 6.

(Example 7)

A starting material having the composition of [Fe$_{0.85}$Ru$_{0.10}$Mn$_{0.05}$Si$_{2.00}$, purity: 5N-molten alloy powder (200 mesh)] prepared by an ordinary alloying method was pulverized with a planetary ball mill at 800 r.p.m. for 24 hours to obtain a raw material powder of average particle size of 4-5 $\mu$ m.

A certain amount of aqueous solution of Mn(NO$_3$)$_2$•6H$_2$O as a starting hydrate was added to 15g of the raw material powder with the rate as shown in Table 1 and the mixture was agitated. 8 ml of 25% aqueous ammonia was added to the mixture being agitated with an agitator at 1,800 r.p.m. for 10 minutes at 20 C and adjusted its pH to 10. Precipitates were obtained.

The precipitates were filtered with a cylindrical paper filter, washed with ion-exchanged water and dried at 90 °C for 10 hours in the atmosphere to obtain a powder.

The powder was pressed with a cool isostactic press at a pressure of 4.0 ton/cm$^2$ for 3 minutes to obtain a shaped article of 5mm× 5mm × 30mm. This shaped article was sintered at 1,150 °C for 24 hours under 10$^{-5}$ torr and further heated at 800°C for 144 hours under 10$^{-5}$ torr to obtain a desired thermo-element.

The measured value of the electrical performance index of the thermo-element obtained at each temperature is shown in Figure 3.

(Comparative Example 4)

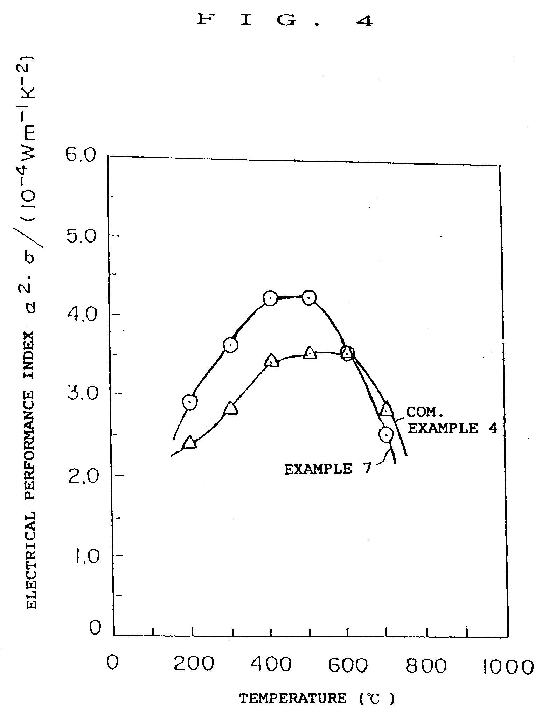

The thermo-element was prepared in substantially the same manner as in Example 7, except for using the raw material powder without the treatment with aqueous solution of chromium nitrate, i.e. the solution containing the salt of the doping metal. The measured value of the electrical performance index of the obtained thermo-element at each temperature is shown in Figure 4.

(Example 8)

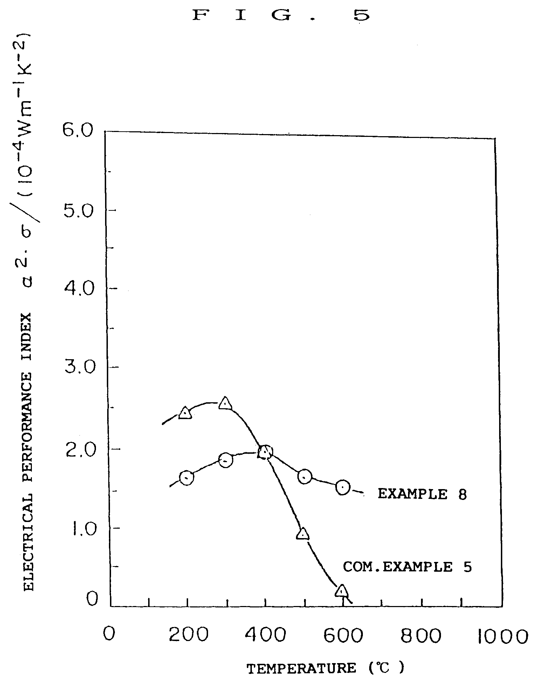

The thermo-element was prepared in substantially the same manner as in Example 7, except for using [Fe$_{0.85}$Ru$_{0.11}$Cr$_{0.04}$Si$_{2.00}$, purity: 5N-molten alloy powder (200 mesh)] as the starting material and aqueous solution of Cr(NO$_3$)$_2$•6H$_2$O as the starting hydrate. The thermoelectric character of the obtained thermo-element at 600°C measured is shown in Table 1. The relationship between the electrical performance index of the obtained thermo-element and the temperature is shown in Figure 5.

(Example 9)

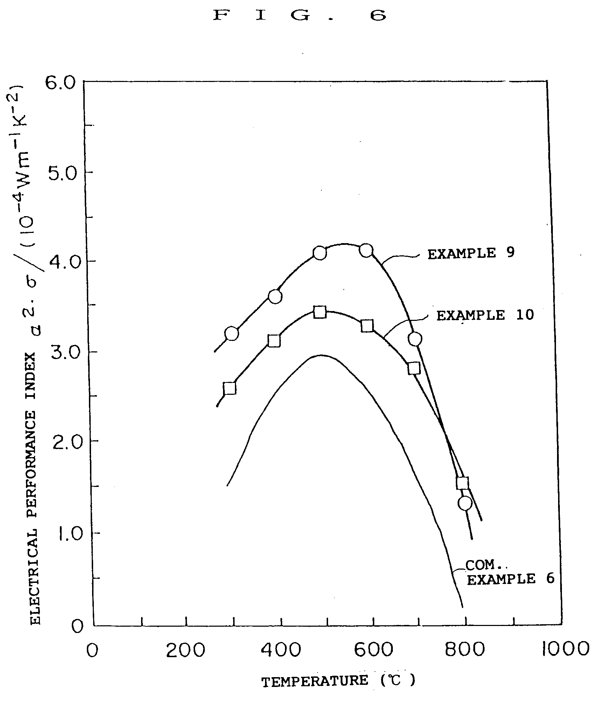

The thermo-element was prepared in substantially the same manner as in Example 7, except for using [Fe$_{0.85}$Ru$_{0.07}$Mn$_{0.08}$Si$_{2.00}$, purity: 5N-molten alloy powder (200 mesh)] as the starting material and 0.1M Mn-(NO$_3$)$_2$ as the starting hydrate with the rate of manganese nitrate being 3.38 parts by weight based on 100 parts by weight of the thermoelectric transformation raw material powder. The measured thermoelectric character of the obtained thermo-element at 600 °C is shown in Table 1. The relationship between the electrical performance index of the obtained thermo-element and the temperature is shown in Figure 6.

(Example 10)

The thermo-element was prepared in substantially the same manner as in Example 7, except for using the starting material being the same as that used in Example 9 and 0.1M $Mn(NO_3)_2$ as the starting hydrate with the rate of manganese nitrate being 5.30 parts by weight based on 100 parts by weight of the thermoelectric transformation raw material powder. The measured thermoelectric character of the obtained thermo-element at 600°C is shown in Table 1. The relationship between the electrical performance index of the obtained thermo-element and the temperature is shown in Figure 6.

(Example 11)

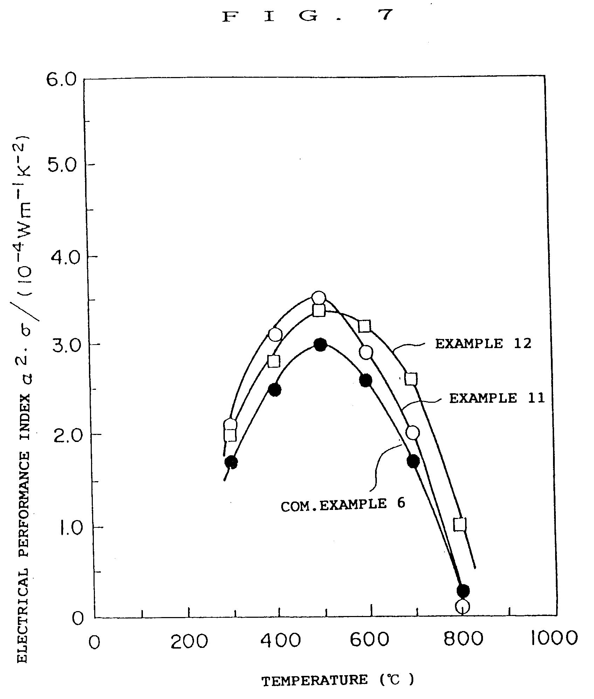

The thermo-element was prepared in substantially the same manner as in Example 7, except for using [$Fe_{0.85}Ru_{0.10}Mn_{0.05}Si_{2.00}$, purity: 5N-molten alloy powder (200 mesh)] as the starting material and 0.1M Mn-$(NO_3)_2$ as the starting hydrate with the rate of manganese nitrate being 3.38 parts by weight based on 100 parts by weight of the thermoelectric transformation raw material powder. The measured thermoelectric character of the obtained thermo-element at 600 °C is shown in Table 1. The relationship between the electrical performance index of the obtained thermo-element and the temperature is shown in Figure 7.

(Example 12)

The thermo-element was prepared in substantially the same manner as in Example 7, except for using the starting material being the same as that used in Example 11 and 0.1M $Mn(NO_3)_2$ as the starting hydrate with the rate of manganese nitrate being 5.30 parts by weight based on 100 parts by weight of the thermoelectric transformation raw material powder. The measured thermoelectric character of the obtained thermo-element at 600°C is shown in Table 1. The relationship between the electrical performance index of the obtained thermo-element and the temperature is shown in Figure 7.

(Comparataive Example 6)

The thermo-element was prepared in substantially the same manner as in Example 7, except that manganese nitrate was not added. The measured thermoelectric character of the obtained thermo-element at 600°C is shown in Table 1. The relationship between the electrical performance index of the obtained thermo-element and the temperature is shown in Figure 7.

* In Examples 7-9 and 11, "purity: 5N-molten alloy powder" means "molten alloy powder being 99.999% in purity".

TABLE 1

| | PARTICLE SIZE OF RAW MATERIAL POWDER ($\mu$ m) | ADDITION AMOUNT OF SALT OF DOPING METAL (weight by %) | ZEEBECK COEFFICIENT $\alpha$ ($\mu$ V K$^{-1}$) | ELECTRICAL CONDUCTIVITY $\sigma$ ($\Omega^{-1}$ m$^{-1}$) | ELECTRICAL PERFORMANCE INDEX $\alpha^2 \sigma$ (W m$^{-1}$ K$^{-2}$) |
|---|---|---|---|---|---|
| EXAMPLE 1 | 3 | Mn(NO$_3$)$_2$ 3.38 | 162 | 113000 | $2.96 \times 10^{-4}$ |
| EXAMPLE 2 | 3 | Mn(NO$_3$)$_2$ 3.38 | 160 | 9700 | $2.48 \times 10^{-4}$ |
| COM.EXAMPLE 1 | 3 | - - | 138 | 8900 | $1.69 \times 10^{-4}$ |
| EXAMPLE 3 | 7 | Mn(NO$_3$)$_2$ 3.38 | 190 | 11200 | $4.04 \times 10^{-4}$ |
| EXAMPLE 4 | 7 | Co(NO$_3$)$_2$ 5.30 | 173 | 20000 | $5.99 \times 10^{-4}$ |
| EXAMPLE 5 | 7 | Co(NO$_3$)$_2$ 5.30 | -142 | 57000 | $11.5 \times 10^{-4}$ |
| COM.EXAMPLE 2 | 7 | - - | -182 | 19000 | $6.3 \times 10^{-4}$ |
| EXAMPLE 6 | 5~6 | Cr(NO$_3$)$_2$ 5.30 | 218 | 8000 | $3.8 \times 10^{-4}$ |
| COM.EXAMPLE 3 | 5~6 | - - | 155 | 4500 | $0.11 \times 10^{-4}$ |
| EXAMPLE 7 | 4~5 | Co(NO$_3$)$_2$ 5.30 | -128 | 21200 | $3.5 \times 10^{-4}$ |
| COM.EXAMPLE 4 | 4~5 | - - | -125 | 22500 | $3.5 \times 10^{-4}$ |
| EXAMPLE 8 | 4~5 | Co(NO$_3$)$_2$ 8.68 | 110 | 12500 | $1.5 \times 10^{-4}$ |
| COM.EXAMPLE 5 | 4~5 | - - | 160 | 5000 | $1.3 \times 10^{-4}$ |
| EXAMPLE 9 | 4~5 | Mn(NO$_3$)$_2$ 3.38 | 178 | 12500 | $4.0 \times 10^{-4}$ |
| EXAMPLE 10 | 4~5 | Mn(NO$_3$)$_2$ 5.30 | 173 | 11000 | $3.3 \times 10^{-4}$ |
| EXAMPLE 11 | 4~5 | Mn(NO$_3$)$_2$ 3.38 | 203 | 7000 | $2.9 \times 10^{-4}$ |
| EXAMPLE 12 | 4~5 | Mn(NO$_3$)$_2$ 5.30 | 207 | 7500 | $3.2 \times 10^{-4}$ |
| COM.EXAMPLE 6 | 4~5 | - - | 195 | 7000 | $2.7 \times 10^{-4}$ |

- Evaluation -

The results summerized in Table 1 and Figures 1-7 show the thermo-element produced using the powder prepared by the process according to the present invention has a high performance index and is especially excellent in performance at a high temperature.

INDUSTRIAL APPLICABILITY

The process according to the present invention can provide a thermo-element with a high performance index and being capable of transforming thermal energy into electricity with a high efficiency so that it is suitable for an electric generator.

**Claims**

1. A process for preparing a thermo-element which comprises mixing a powdery thermoelectric transformation raw material and a solution containing a doping metal to produce a powder, pressing the powder into a shaped article and sintering the shaped article.

2. A process according to Claim 1 wherein the powdery thermoelectric transformation raw material is an alloy obtained by substituting a doping metal for a part of $FeSi_2$.

3. A process according to Claim 1 wherein the powdery thermoelectric transformation raw material is an alloy represented by the following formula:

$$Fe_{1-z}M^1_zSi_2$$

wherein z is 0 to 0.2 and $M^1$ is at least one metal selected from the group consisting of Mn, Cr, Co, Ni and Al.

4. A process according to Claim 1 wherein the powdery thermoelectric transformation raw material is an alloy represented by the following formula:

$$Fe_{1-(x+y)}M^2_xM^3_ySi_2$$

wherein $M^2$ is at least one metal selected from the group consisting of Mn, Cr, Co, Ni and Al, $M^3$ is Ru or Os and (x + y) is 0.1 to 0.3.

5. A process according to Claim 1 wherein the doping metal is at least one metal selected from the group consisting of Mn, Cr, Co, Ni and Al.

6. A process according to Claim 1 wherein the solution containing a doping metal is an aqueous solution of a salt of the doping metal or a solution of an organometallic compound containing the doping metal.

FIG. 1

F I G . 2

FIG. 3

F I G . 4

# F I G . 5

F I G . 6

F I G . 7

# INTERNATIONAL SEARCH REPORT

International Application No PCT/JP92/00089

## I. CLASSIFICATION OF SUBJECT MATTER (if several classification symbols apply, indicate all) 6

According to International Patent Classification (IPC) or to both National Classification and IPC

Int. Cl$^5$   C04B35/58, H01L35/34

## II. FIELDS SEARCHED

| | Minimum Documentation Searched 7 |
|---|---|
| Classification System | Classification Symbols |
| IPC | C04B35/58, C01B33/06, H01L35/34 |

Documentation Searched other than Minimum Documentation
to the Extent that such Documents are Included in the Fields Searched 8

| | |
|---|---|
| Jitsuyo Shinan Koho | 1916 – 1992 |
| Kokai Jitsuyo Shinan Koho | 1971 – 1992 |

## III. DOCUMENTS CONSIDERED TO BE RELEVANT 9

| Category * | Citation of Document, 11 with indication, where appropriate, of the relevant passages 12 | Relevant to Claim No. 13 |
|---|---|---|
| Y | JP, A, 3-8707 (Mitsubishi Metal Corp.), January 16, 1991 (16. 01. 91), Line 1, left column to line 14, right column, page 1, lines 3 to 8, lower part, right column, page 2, page 3 (all), Table 1 cont. 2 of page 4, line 14, left column to line 1, right column, page 6 (Family: none) | 1-3, 5 |
| A | JP, B2, 1-31453 (Futaba Denshi Kogyo K.K.), June 26, 1989 (26. 06. 89), Lines 1 to 20, left column, page 1, lines 28 to 35, right column, page 4 & US, A, 4539054 | 1-3, 5 |
| A | JP, B2, 2-8466 (Futaba Denshi Kogyo K.K.), February 23, 1990 (23. 02. 90), Lines 1 to 16, left column, page 1 & US, A, 4500742 | 1 |
| A | JP, A, 2-214176 (Hitachi, Ltd.), August 27, 1990 (27. 08. 90), | 1 |

* Special categories of cited documents: 10

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search | Date of Mailing of this International Search Report |
|---|---|
| April 17, 1992 (17. 04. 92) | May 12, 1992 (12. 05. 92) |

| International Searching Authority | Signature of Authorized Officer |
|---|---|
| Japanese Patent Office | |

Form PCT/ISA/210 (second sheet) (January 1985)

**FURTHER INFORMATION CONTINUED FROM THE SECOND SHEET**

Line 1, left column to
line 13, right column, page 1
(Family: none)

---

**V.☐ OBSERVATIONS WHERE CERTAIN CLAIMS WERE FOUND UNSEARCHABLE** [1]

This international search report has not been established in respect of certain claims under Article 17(2) (a) for the following reasons:

1.☐ Claim numbers          , because they relate to subject matter not required to be searched by this Authority, namely:

2.☐ Claim numbers          , because they relate to parts of the international application that do not comply with the prescribed requirements to such an extent that no meaningful international search can be carried out, specifically:

3.☐ Claim numbers          , because they are dependent claims and are not drafted in accordance with the second and third sentences of PCT Rule 6.4(a).

---

**VI.☐ OBSERVATIONS WHERE UNITY OF INVENTION IS LACKING** [2]

This International Searching Authority found multiple inventions in this international application as follows:

1.☐ As all required additional search fees were timely paid by the applicant, this international search report covers all searchable claims of the international application.

2.☐ As only some of the required additional search fees were timely paid by the applicant, this international search report covers only those claims of the international application for which fees were paid, specifically claims:

3.☐ No required additional search fees were timely paid by the applicant. Consequently, this international search report is restricted to the invention first mentioned in the claims; it is covered by claim numbers:

4.☐ As all searchable claims could be searched without effort justifying an additional fee, the International Searching Authority did not invite payment of any additional fee.

Remark on Protest

☐ The additional search fees were accompanied by applicant's protest.

☐ No protest accompanied the payment of additional search fees.

Form PCT/ISA/210 (supplemental sheet (2)) (January 1985)